(19) Europäisches Patentamt

European Patent Office

Office européen des brevets

(11) Veröffentlichungsnummer: **0 618 672 A1**

## (12) EUROPÄISCHE PATENTANMELDUNG

(21) Anmeldenummer: **94103828.3**

(22) Anmeldetag: **12.03.94**

(51) Int. Cl.⁵: **H03D 3/00**

(30) Priorität: **31.03.93 DE 4310462**

(43) Veröffentlichungstag der Anmeldung:
**05.10.94 Patentblatt 94/40**

(84) Benannte Vertragsstaaten:
**AT CH ES FR GB IT LI NL**

(71) Anmelder: **ANT Nachrichtentechnik GmbH**
**Gerberstrasse 33**
**D-71522 Backnang (DE)**

(72) Erfinder: **Göckler, Heinz, Dr.**
**Elbinger Strasse 52**
**D-71522 Backnang (DE)**

(54) Verfahren zur Demodulation von frequenzmodulierten Signalen.

㊲ Verfahren zur Demodulation von frequenzmodulierten Signalen, wobei das Empfangssignal abgetastet wird, mit einem Bandfilter, das komplexwertige Koeffizienten aufweist, gefiltert wird, anschließend differenziert wird und nach einer Betragsbildung das gewünschte Phaseninkrement gewonnen wird.

Sehr aufwandsgünstiges Verfahren, das einen Einsatz insbesondere bei der Demodulation von UKW-FM-Signalen empfiehlt.

Die Erfindung betrifft ein Verfahren zur Demodulation von frequenzmodulierten Signalen gemäß Oberbegriff des Anspruches 1. Solche digitale Verfahren zur Demodulation von kontinuierlich modulierten FM-Signalen, also nicht FSK, welche zum eigentlichen Demodulationsprozeß komplexwertige Signale benötigen und verarbeiten, sind bekannt, beispielsweise durch den Aufsatz "Equalization Problems in a digital FM Receiver" von Kammeyer in Signal Processing 9 (1985) Seiten 263-276, wobei es sich um einen sogenannten Verzögerungsdemodulator handelt.

Aus der Dissertation "Die Demodulation frequenzumgetasteter Signale mit Bandbreiten in der Größenordnung der Mittenfrequenz" von Ruopp, Universität Stuttgart 1975 ist die Blockstruktur eines mit Differentiation arbeitenden Demodulationsverfahren bekannt geworden.

Bei all diesen Verfahren ist es erforderlich, aus dem ursprünglich reellwertigen FM-Eingangssignal $g_o(t)$ ein komplexwertiges Signal abzuleiten in Form einer Normal- und einer Quadraturkomponente (Real- und Imaginärteil). Diese Komponenten werden erzeugt, indem das abgetastete Eingangssignal mit zwei zueinander orthogonalen Trägersignalen multipliziert wird (Mischer) und anschließend mittels zweier nachgeschalteter identischer Tiefpässe zur Unterdrückung unerwünschter Mischprodukte gefiltert werden.

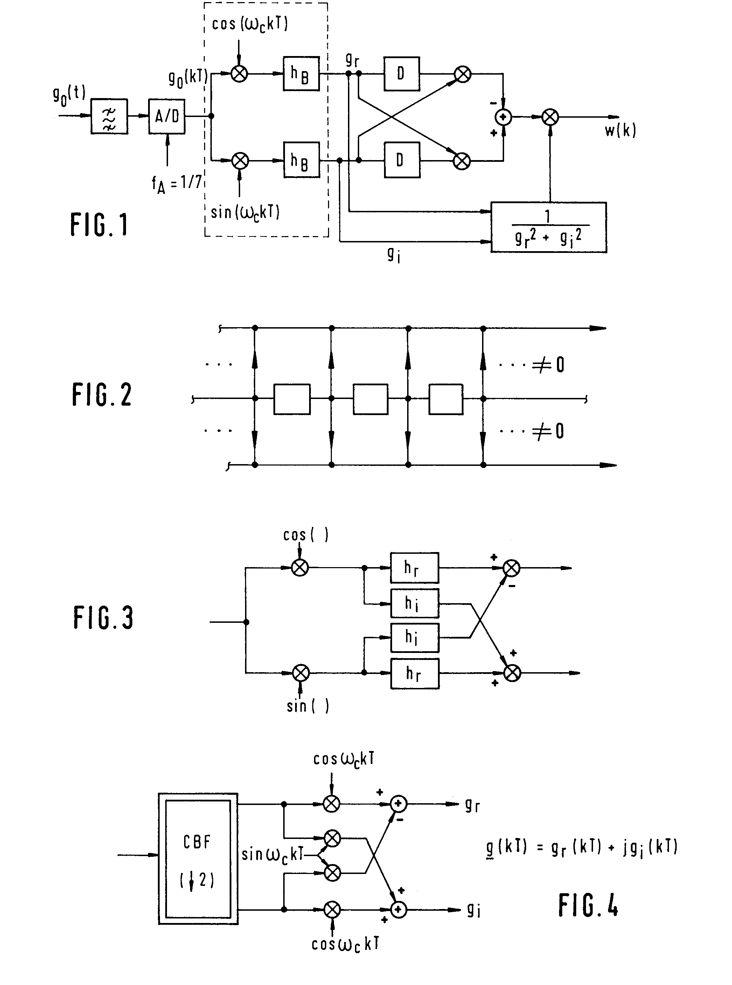

Die dazu notwendige Schaltungsanordnung ist in Figur 1 strichliert umrandet.

Wenn die Filterkombination $h_B$ zusätzlich die Aufgabe übernehmen soll, den bezüglich der Mittenfrequenz unsymmetrischen Frequenzgang des analogen Vorfilters zu entzerren, dann enthält der gestrichelte Block der Figur 1 vier Teilfilter, wie in Figur 3 gezeigt wird.

Der vorliegenden Erfindung lag die Aufgabe zugrunde, ein Verfahren der eingangs genannten Art anzugeben, welches in der Lage ist, Demodulationssignale gleicher oder sogar höherer Qualität zu erzeugen unter Verminderung des Aufwandes.

Diese Aufgabe wurde gelöst mit den Mitteln des Anspruches 1. Vorteilhafte Ausgestaltungen ergeben sich durch die Unteransprüche.

Das erfindungsgemäße Demodulationsverfahren erfordert wesentlich weniger Schaltungsaufwand und liefert qualitativ mindestens gleichwertige Demodulationsprodukte. Das Verfahren ist auch dann anwendbar, wenn beliebige Frequenzverschiebung gewünscht wird.

Es folgt nun die Beschreibung anhand der Figuren.

Die Figur 1 zeigt das grundlegende Blockdiagramm für einen digitalen FM-Demodulator nach einem fiktiven Stande der Technik.

Die Figur 3 zeigt die Anordnung aus vier Teilfiltern, wenn die Filterkombination $h_B$ in dem strichlierten Block der Figur 1 zusätzlich die Aufgabe der Entzerrung übernimmt.

In Figur 4 ist eine Anordnung dargestellt, die nach dem erfindungsgemäßen Verfahren arbeitet und den strichlierten Block der Fig. 1 ersetzt.

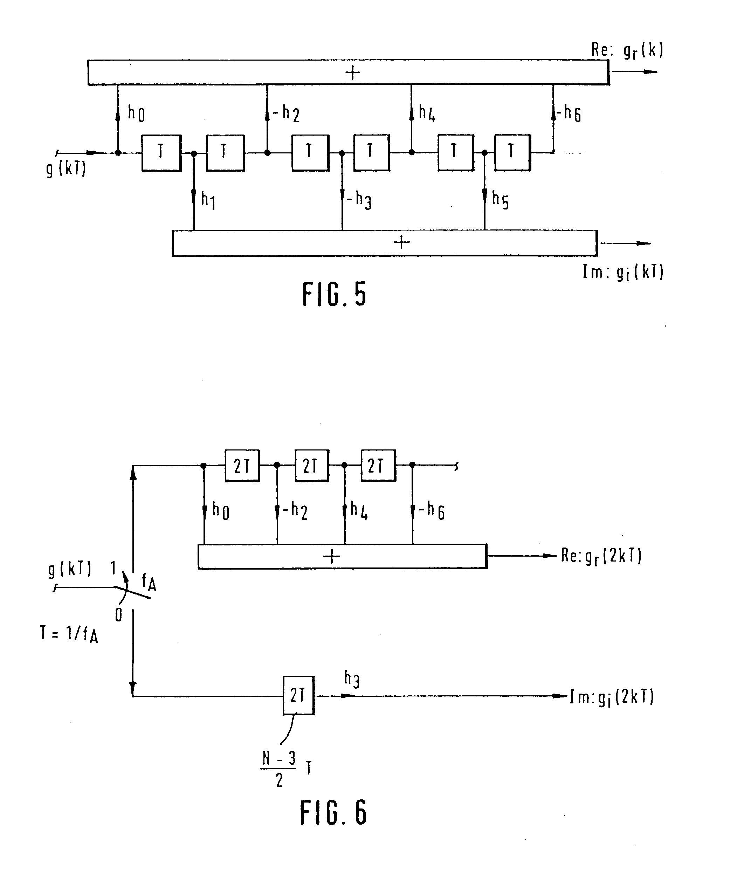

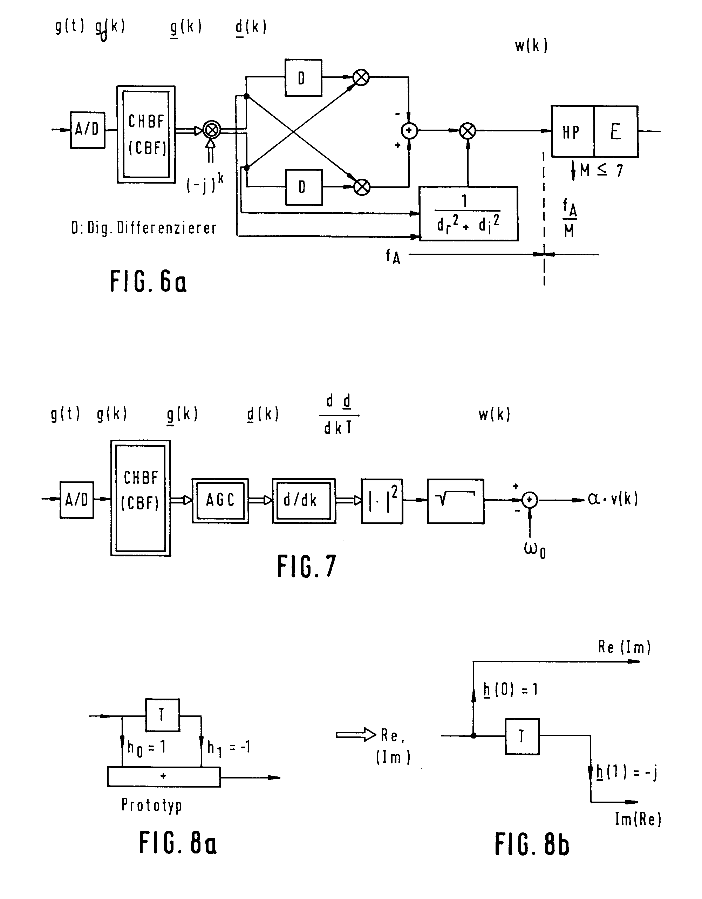

Die Figuren 2, 5 und 6 schließlich zeigen Filter-Anordnungen, die vorteilhaft als Bandfilter CBF bzw. CHBF eingesetzt werden können, wobei die Anordnungen nach Fig. 5 und Fig. 6 Strukturen für ein Prototypfilter zur Erzeugung eines komplexwertigen Ausgangssignals aus einem reellwertigen Eingangssignal sind.

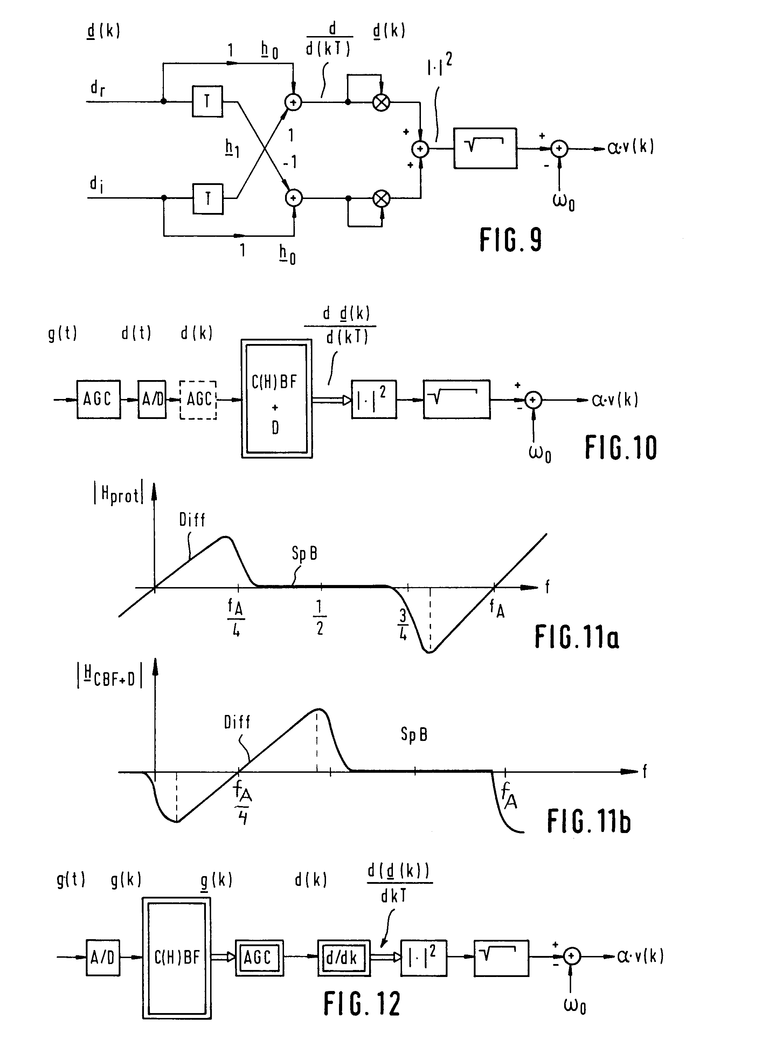

In den Fig. 6a, 7, 9, 10 und 12 sind Blockschaltbilder für erfindungsgemäße Demodulator-Varianten abgebildet. Die Fig. 8 gibt zwei einfache Differenzierer wieder, und in Fig. 11 sind die Übertragungscharakteriska zweier Differenzierer über der Frequenz aufgetragen.

Im Blockschaltbild gemäß Figur 1 werden die einzelnen Verarbeitungsschritte des eingangsseitigen Empfangssignals gezeigt:

Das durch den Zwischenfrequenzmischer in eine Zwischenfrequenzlage heruntergemischte Empfangssignal $g_0(t)$ wird über ein analoges Vorfilter auf einen Analog/Digitalumsetzer geleitet, abgetastet und anschließend mittels zweier orthogonalen Trägersignale in ein komplexwertiges Signal gewandelt, welches über die Tiefpaßfilterfunktion $h_B$ in beiden Zweigen von störenden Mischprodukten befreit wird.

Den Filtern $h_B$ folgt ein Differentiations-Demodulator, welcher nach folgenden Gleichungen arbeitet:

$$\underline{d}(kT) = d_r(kT) + j \cdot d_i(kT) = a(kT) \cdot e^{j\{\Delta\omega kT + \gamma(kT)\}}$$
$$= a(k) \cdot e^{j\gamma(kT)} \qquad (9)$$

$$\phi(kT) = \Delta\omega kT + \psi(kT) = \arctan d_i(k)/d_r(k) \qquad (28)$$

2

$$w(kT) = d\phi(kT)/d(kT) = \Delta\omega + \Delta\Omega \cdot v(kT)$$
$$= d/d(kT) \cdot \arctan d_i(kT)/d_r(kT)$$
$$= (d_r d_i' - d_i d_r')/(d_r^2 + d_i^2) \tag{29}$$

Am Ausgang der Schaltung entsteht w(k), das gewünschte Phaseninkrement.

Das Blockschaltbild der Figur 6a enthält den gleichen Differentiations-Demodulator, die Aufbereitung am Eingang des Demodulators erfolgt jedoch nach der erfindungsgemäßen Weise, die prinzipiell aus Figur 4 zu entnehmen ist und in dem Falle der Figur 6a eine besonders unaufwendige komplexe Multiplikation mit $(-j)^k$ als Frequenzumsetzung nach 0 ergibt, da hier die Signalmittenfrequenz zu $f_A/4$ angenommen wurde. Der Differenzierer D kann in erster Näherung mit einem Verzögerungsglied und einem Addierer gemäß Figur 8a realisiert werden; allerdings treten bei nichtidealen Differenzierern nichtlineare Verzerrungen auf. Der Vorteil der unaufwendigen Schaltung nach Figur 6a liegt auch darin, daß eine automatische Amplitudenregelung nicht erforderlich ist, da die Amplitudennormierung durch die Division durch $d_r^2 + d_i^2$ erfolgt.

Die Figur 7 zeigt einen anderen Aufbau eines Demodulators ebenfalls mit Differentiation. Nach der Analog-Digitalumsetzung und Filterung mit einem Bandfilter CHBF bzw. CBF und einer automatischen Amplitudenregelung AGC, welch letztere auch vor der Filterung oder vor der Analog-Digitalumsetzung erfolgen kann, wird das gefilterte Empfangssignal $\underline{d}(k) = a(k) \cdot e^{j\phi(kT)}$ differenziert. Daraus erhält man

$$\frac{d}{dk}\{a(k) \cdot e^{j\phi(k)}\} = a' \cdot e^{j\phi} + a \cdot e^{j\phi} \cdot \frac{d\phi}{dk}$$

$$= e^{j\phi}(a' + a \cdot d\phi/dk) \tag{30}$$

Hieraus ist $d\phi/dkT$ nur dann zu gewinnen, wenn a(k) bekannt oder als konstant anzusetzen ist. Letzteres ist der Fall durch die vorausgegangene Amplitudenregelung. Deshalb erhält man mit a(k) = konstant

$$d\underline{d}(k)/dk = d\underline{g}(k)/dk = d\phi/dk \cdot e^{j\phi} \tag{31}$$

$$\left|\frac{d\phi}{dk} \cdot e^{j\phi}\right| = \omega_0 + \Delta\Omega v(k) > 0 \tag{32}$$

Der Differenzierer muß seinen Nulldurchgang bei $f_A/4$ ungefähr $f_0$ aufweisen (siehe Figur 11b), da ja keine Frequenzumsetzung erfolgt ist. Dies erreicht man mit Hilfe eines Differenziererprototypen mit reellen Koeffizienten, dessen Übertragungscharakteristik über der Frequenz in Figur 11a aufgetragen ist, durch Multiplikation seiner reellen Koeffizienten mit

$$e^{j2\pi k f_A/4 f_A} = j^k \quad :$$

$$\underline{h}(k) = h(k) \cdot e^{j2\pi(f_A/4 f_A) \cdot k}$$
$$= h(k) \cdot e^{jk\pi/2} = h(k) \cdot j^k \tag{33}$$

Am Beispiel des einfachsten Falles eines Differenzierers nämlich dem mit dem Grad 1 (ein Verzögerungsglied) und N = 2 Koeffizienten, der im Gegensatz zu den in Figur 11 abgebildeten Übertragungscharakteristika einen sinusförmigen Verlauf aufweist, sei die Ableitung veranschaulicht. Der Prototyp hat die Struktur gemäß Figur 8a und die Koeffizienten $h_0 = 1$ und $h_1 = -1$. Aus bzw. mit Gleichung (33) folgt

$\underline{h}(0) = h(0) = 1$
$\underline{h}(1) = jh(1) = -j.$

Damit erhält man einen Differenzierer mit komplexen Koeffizienten und der Struktur gemäß Figur 8b, welcher sowohl für den Realzweig als auch für den Imaginärteil-Zweig einzusetzen ist.

Mit diesem einfachsten Differenzierer erhält man eine Struktur gemäß Figur 9. Aus dem abgetasteten, geregelten und gefilterten Eingangssignal $\underline{d}(k) = d_r + jd_i$ entstehen nach der Doppeldifferenziererschaltung aus zwei Verzögerungsgliedern T und den beiden Addierern, die Ableitungen $d'_i$ und $d'_r$, welche anschließend mit sich selber multipliziert, d.h. quadriert und zusammengefaßt werden. Nach dem Block Wurzelbildung wird die Bezugsfrequenz $\omega_0$ subtrahiert, und man erhält das gewünschte übertragene Signal v(k), allerdings noch mit $\alpha$ skaliert.

Das Blockschaltbild der Figur 10 verwendet die gleiche Differentiationsmethode wie diejenige nach Figur 7 bzw. 9, allerdings mit dem Unterschied, daß die automatische Amplitudenregelung unmittelbar vor oder nach der Analog-Digitalumsetzung erfolgt. Außerdem sind die Funktionen der Filterung mit dem komplexen Bandfilter CBF bzw. Halbbandfilter CHBF und die Funktion des Differenzierens zusammengefaßt, was weiterhin zu Aufwandseinsparungen führt. Auch hier muß der Nulldurchgang des Differenzierers bei $f_0$ ungefähr $f_A/4$ liegen, und das Filter muß einen Sperrbereich um $3f_A/4$ aufweisen, siehe Figur 11b. Auch diese Charakteristik läßt sich aus einem Prototyp eines reellen Differenzierers mit Sperrbereich der Charakteristik nach Figur 11a ableiten.

Eine weitere Variante eines Demodulators auf Differentiationsbasis zeigt das Blockschaltbild gemäß Figur 12, wobei der Differenzierer d/dkT aus Figur 7 nur mit einem reellen Signal gespeist wird, wodurch der Differenzierer nur den halben Aufwand erfordert gegenüber den anderen Varianten. Sein Frequenzgang entspricht etwa dem von Figur 11b, wobei aber der Sperrbereich um $3f_A/4$ nicht erforderlich ist.

**Patentansprüche**

1. Verfahren zur Demodulation von frequenzmodulierten Signalen der Form g(t) = a(t) $\cdot$ Cosinus [$\phi$(t)] mit der Augenblicksfrequenz $\omega(t) = d\phi(t)/dt = \omega_0 [1 + \alpha \cdot v(t)]$, wobei das Empfangssignal $g_0$(t) mit der Abtastfrequenz $f_A = 1/T$ abgetastet wird zu

$$g_O(k) = a(k) \cdot \cos [\Psi(kT)]$$
$$= a(k) \cdot \cos [\omega_O kT + \Psi(kT)],$$

$$\text{mit } \Psi(k) \approx \Delta\Omega \cdot T \sum_{-\infty}^{k} v(k),$$

mit dem übertragenen Signal v(k), der Schrittzahl k, der Schritt-Taktlänge T, dem Frequenzhub $\Delta\Omega = \alpha \cdot \omega_0$, der Bezugsfrequenz $\omega_0 = 2\pi f_0$ und mit der durch Bandbegrenzung auf der Übertragungsstrecke bedingten in zeitlicher Abhängigkeit t schwankenden Amplitude a(t) bzw. a(k), wobei mittels Tiefpaßfilter (zur Unterdrückung unerwünschter Spektralanteile) gefiltert ($h_B$) wird zu $\underline{g}$(kT),
dadurch gekennzeichnet,
daß das abgetastete Empfangssignal $g_o$(kT) zuerst einer Filterung mit einem Bandfilter unterzogen wird, wobei dieses Filter komplexwertige Koeffizienten $\underline{h}$(k) aufweist (Quadratur-Erzeugung QE; $\underline{g}$(k) = $g_0$(kT)$\cdot\underline{h}$(k)), und daß dann mittels komplexer) Differentiation das gewünschte Phaseninkrement

$$\frac{d\Psi(kT)}{dkT} = w(k) = \omega_0 [1 + \alpha \cdot v(k)]$$

erzeugt wird.

2. Verfahren nach Anspruch 1, dadurch gekennzeichnet, daß das gefilterte Empfangssignal $\underline{g}$(k) mittels einer komplexen Trägermultiplikation

$\underline{d}(k) = \underline{g}(k) \cdot e^{j\omega_c kT}$

4

EP 0 618 672 A1

eine Frequenzverschiebung nach f≈0 erfährt.

3. Verfahren nach Anspruch 2, dadurch gekennzeichnet, daß die Differentiation am Arctan-Argument des Quotienten aus Imaginär- und Realteil des komplexen gefilterten und frequenzverschobenen Empfangssignals $\underline{d}(k)$ erfolgt:

$$w(k) = \frac{d\,\varphi\,(kT)}{dkT} = \omega_0 + \Delta\,\Omega \cdot v(k) \qquad (28)$$

$$= \frac{d}{dkT}\,arc\,tan\,\frac{d_i(kT)}{d_r(kT)} = \frac{d_r d_i' - d_i \cdot d_r'}{d_i^2 + d_r^2} \qquad (29)$$

(Fig. 6a)

4. Verfahren nach Anspruch 1, dadurch gekennzeichnet, daß spätestens nach der Filterung eine automatische Amplitudenregelung erfolgt (AGC); (Fig. 7).

5. Verfahren nach Anspruch 4, dadurch gekennzeichnet, daß die automatische Amplitudenregelung (AGC) unmittelbar vor oder nach der Analog-Digital-Umsetzung (ADU) durchgeführt wird (Fig. 7).

6. Verfahren nach Anspruch 4 oder 5, dadurch gekennzeichnet, daß das gefilterte und amplitudengeregelte Empfangssignal $\underline{d}(k)$ einer Differentiation unterzogen wird:

$$\frac{d\underline{d}(kT)}{dkT} = \frac{d}{dkT}\{a(kT) \cdot e^{j\,\varphi\,(kT)}\} = a' \cdot e^{j\,\varphi} + a(kT) \cdot e^{j\,\varphi} \cdot \frac{d\varphi}{dkT} \qquad (30)$$

$$\approx a(kT) \cdot e^{j\,\varphi} \cdot \frac{d\varphi}{dkT} \qquad (31)$$

(Fig. 7)

7. Verfahren nach Anspruch 6, dadurch gekennzeichnet, daß nach der Differentiation die Wurzel aus der Summe der Quadrate von Imaginär- und Realteil

$$\left|\frac{d\varphi}{dkT} \cdot e^{j\,\varphi}\right| = \left|\frac{d\underline{d}(kT)}{dkT}\right| = \sqrt{d_i'^2 + d_r'^2}$$

und damit das Phaseninkrement w(k) gebildet (erzeugt) wird ( Fig.7 und 9).

8. Verfahren nach einem der vorhergehenden Ansprüche, dadurch gekennzeichnet, daß von dem Phaseninkrement w(k) die Bezugsfrequenz $\omega_0$ subtrahiert wird zu $\alpha \cdot v(k)$.

9. Verfahren nach Anspruch 5, 6, 7 und 8, dadurch gekennzeichnet, daß die Funktion Differentiation zusammen mit der Band-Filterung (CBF, CHBF) im Bandfilter durchgeführt werden. (Fig. 10).

10. Verfahren nach Anspruch 6, 7, 8 oder 9, dadurch gekennzeichnet, daß die Differentiation am reellen abgetasteten und gefilterten Empfangssignal d(k) erfolgt (Fig. 12).

11. Verfahren nach einem der vorhergehenden Ansprüche, dadurch gekennzeichnet, daß das Phaseninkrement w(k) über einen Hochpaß (HP) gefiltert wird.

5

**12.** Verfahren nach Anspruch 11, dadurch gekennzeichnet, daß der Hochpaß (HP) mit einer M-fach niedrigeren Abtastrate $f_A/M$ arbeitet.

**13.** Verfahren nach Anspruch 11 oder 12, dadurch gekennzeichnet, daß nach der Hochpaß-Filterung (HP) entzerrt wird (E).

**14.** Verfahren nach einem der vorhergehenden Ansprüche, dadurch gekennzeichnet, daß die komplexwertigen Koeffizienten $\underline{h}(k)$ des Bandfilters aus einem Filter mit reellen Koeffizienten h(k) abgeleitet sind.

**15.** Verfahren nach einem der vorhergehenden Ansprüche, dadurch gekennzeichnet, daß vor der Analog-Digital-Umsetzung (ADU) eine analoge Band- oder Tiefpaß-Filterung erfolgt.

**16.** Verfahren nach einem der vorhergehenden Ansprüche, dadurch gekennzeichnet, daß das komplexe Bandfilter (CBF) eine FIR-Struktur (mit endl. Impuls.-Antwort) aufweist.

**17.** Verfahren nach Anspruch 16, dadurch gekennzeichnet, daß das komplexe Bandfilter (CBF) ein komplexes Halbbandfilter (CHBF) ist.

**18.** Verfahren mach einem der vorhergehenden Ansprüche, dadurch gekennzeichnet, daß ein im demodulierten Signal (Phaseninkrement w(K)) vorhandener Gleichanteil dazu herangezogen wird, um die Frequenz $\omega_c$ für die Trägermultiplikation $\underline{g}(k) = \underline{g}'(k) \, e^{-j\omega_c kT}$ auf den korrekten Wert zu regeln (korrekte Einstellung bei verschwindendem Gleichanteil), (Fig. 1, 3 und 4).

6

FIG.1

FIG.2

FIG.3

$$\underline{g}(kT) = g_r(kT) + jg_i(kT)$$

FIG.4

Re: $g_r(k)$

$h_0$    $-h_2$    $h_4$    $-h_6$

$g(kT)$    T    T    T    T    T    T

$h_1$    $-h_3$    $h_5$

Im: $g_i(kT)$

## FIG. 5

2T    2T    2T

$h_0$    $-h_2$    $h_4$    $-h_6$

Re: $g_r(2kT)$

$g(kT)$    1    $f_A$

$T = 1/f_A$    0

$h_3$

2T    Im: $g_i(2kT)$

$\dfrac{N-3}{2}T$

## FIG. 6

EP 0 618 672 A1

FIG. 6a

FIG. 7

Prototyp

FIG. 8a

FIG. 8b

9

$\underline{d}(k)$

$\dfrac{d}{d(kT)}$   $\underline{d}(k)$

$|\cdot|^2$

1   $\underline{h}_0$

$d_r$   T

1

$\underline{h}_1$

-1

$d_i$   T

1   $\underline{h}_0$

$\alpha \cdot v(k)$

$\omega_0$

## FIG. 9

$g(t)$   $d(t)$   $d(k)$   $\dfrac{d\,\underline{d}(k)}{d(kT)}$

AGC   A/D   AGC   C(H)BF + D   $|\cdot|^2$   $\sqrt{\phantom{x}}$   $\alpha \cdot v(k)$

$\omega_0$

## FIG. 10

$|H_{prot}|$

Diff

SpB

$\dfrac{f_A}{4}$   $\dfrac{1}{2}$   $\dfrac{3}{4}$   $f_A$   $f$

## FIG. 11a

$|\underline{H}_{CBF+D}|$

Diff

SpB

$\dfrac{f_A}{4}$   $f_A$   $f$

## FIG. 11b

$g(t)$   $g(k)$   $\underline{g}(k)$   $d(k)$   $\dfrac{d(\underline{d}(k))}{dkT}$

A/D   C(H)BF   AGC   d/dk   $|\cdot|^2$   $\sqrt{\phantom{x}}$   $\alpha \cdot v(k)$

$\omega_0$

## FIG. 12

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| X | EP-A-0 486 095 (PHILIPS' GLOEILAMPENFABRIEKEN) * Seite 2, Zeile 51 - Seite 6, Zeile 29; Abbildung 1 * --- | 1,2,16 | H03D3/00 |
| A | DE-A-38 41 388 (TOSHIBA K.K.) * Seite 2, Zeile 66 - Seite 4, Zeile 24; Abbildungen 2-5 * --- | 3 | |
| A | EP-A-0 148 018 (BLAUPUNKT-WERKE) * Seite 4, Zeile 18 - Seite 7, Zeile 33; Abbildung 1 * --- | 1,4 | |
| D,A | SIGNAL PROCESSING, Bd.9, Nr.4, Dezember 1985, NORTH-HOLLAND Seiten 263 - 267 KAMMEYER 'EQUALIZATION PROBLEMS IN A DIGITAL FM RECEIVER' * Seite 264, Zeile 8 - Seite 265, Zeile 8; Abbildung 1 * ----- | 1,4 | |

**RECHERCHIERTE SACHGEBIETE (Int.Cl.5)**

H03D
H03H

Der vorliegende Recherchenbericht wurde für alle Patentansprüche erstellt

| Recherchenort | Abschlußdatum der Recherche | Prüfer |
|---|---|---|
| DEN HAAG | 22. April 1994 | Dhondt, I |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P04C03)